Europäisches Patentamt

European Patent Office

Office européen des brevets

(11) Numéro de publication: **0 237 094**
**A1**

## (12) DEMANDE DE BREVET EUROPEEN

(21) Numéro de dépôt: **87200246.4**

(22) Date de dépôt: **17.02.87**

(51) Int. Cl.4: **H03K 19/094** , H03K 19/173

(30) Priorité: **18.02.86 FR 8602150**

(43) Date de publication de la demande:
**16.09.87 Bulletin 87/38**

(84) Etats contractants désignés:
**DE FR GB IT**

(71) Demandeur: **Laboratoires d'Electronique et de Physique Appliquée L.E.P.**
**3, Avenue Descartes**
**F-94450 Limeil-Brévannes(FR)**
**FR**
Demandeur: **N.V. Philips' Gloeilampenfabrieken**
**Groenewoudseweg 1**
**NL-5621 BA Eindhoven(NL)**
**DE GB IT**

(72) Inventeur: **Chantepie, Bernard**
**Société Civile SPID 209 rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Dispositif semi-conducteur du type réseau de portes prédiffusé pour circuits à la demande.**

(57) Dispositif semiconducteur du type réseau de portes élémentaires prédiffusé pour constituer un circuit intégré dit circuit à la demande, réalisé selon une technologie de circuit intégré sur arséniure de gallium, caractérisé en ce que les portes élémentaires qui contituent les éléments du réseau prédiffusé réalisent les fonctions OU/NON-OU en logique dite SCFL et constituent à la fois des portes internes (PI) pour le circuit à la demande et des portes externes (PE) compatibles avec la logique dite ECL pour connecter directement le circuit ainsi formé à un dispositif semiconducteur extérieur réalisé dans ladite logique ECL.

<u>Application</u> : Fabrication de "circuits à la demande" ultra-ultrarapides réalisés sur arséniure de gallium, en outre compatibles avec les circuits ECL.

FIG.1a

## DISPOSITIF SEMICONDUCTEUR DU TYPE RESEAU DE PORTES PREDIFFUSE POUR CIRCUITS A LA DEMANDE

L'invention concerne un dispositif semiconducteur du type réseau de portes élémentaires prédiffusé, réalisé selon une technologie de circuit intégré sur arséniure de gallium pour constituer un circuit intégré dit "circuit à la demande".

Par "circuit à la demande" il faut entendre un circuit intégré réalisé par une collaboration entre un concepteur de circuits et un client utilisateur de circuits. Le concepteur de circuits propose sur catalogue des circuits intégrés qui sont essentiellement constitués de portes élémentaires ou de blocs de fonctions élémentaires, distribués en forme de réseau sur un substrat et dépourvus d'interconnexions. Le concepteur est en mesure de fournir à l'utilisateur toutes les caractéristiques de ces portes ou de ces blocs de fonctions, telles que par exemple, leur nombre, la technologie dans laquelle ils sont réalisés ou avec laquelle ils sont compatibles, leur consommation, les entrances et sortances, la position et le nombre des entrées et sorties etc. . . En effet, le circuit proposé par le concepteur a d'abord été "prédiffusé" et ainsi les portes ou les blocs ont été testés.

Partant d'un cahier des charges fourni par le concepteur de circuit, l'utilisateur établit un projet de "routage", c'est-à-dire d'interconnexions entre les portes ou les blocs qui lui sont proposés. Après cette étape, le concepteur de circuit réalise le circuit final conforme "à la demande" de l'utilisateur.

L'étude et la mise au point du jeu de masques pour réaliser les portes élémentaires ou les blocs de fonctions, leur répartition en réseau sur une pastille de semiconducteur, puis leur diffusion et les tests de leurs performances sont faits une fois pour toutes par le concepteur.

Au moment de la "demande" de l'utilisateur, la position géométrique des éléments de base, c'est-à-dire des portes ou groupes de portes de complexité variable selon le type de logique choisi, est figée. Seule, la personnalisation des interconnexions propres à l'utilisateur et à son application, est le paramètre technologique et électrique variable, qui reste à déterminer.

Le cahier des charges ne porte pas à la connaissance de l'utilisateur le jeu de masques pour réaliser les portes ou les blocs de fonctions. Ces derniers lui apparaissent sous la forme d'un réseau de "boîtes noires" munies d'entrées et sorties, chaque boîte noire représentant une fonction logique par exemple OU, NON-OU etc.

C'est donc le concepteur de circuit qui constituera également le jeu de masques pour réaliser le routage.

Or, dans l'état actuel de la technique, la logique dite ECL (de l'anglais Emiter Coupled Logic) réalisée sur silicium, reste une technologie très performante du fait que les portes présentent un temps de propagation très court. C'est pourquoi elle est couramment utilisée. Ainsi de nombreux utilisateurs de circuits possèdent tout ou partie de leur équipement réalisé en cette technologie.

Cependant la logique ECL présente deux désavantages. Le temps de propagation d'une porte reste environ double du temps de propagation d'une porte réalisée sur arséniure de gallium (GaAs). De plus la consommation d'une porte ECL est environ 10 fois supérieure à celle d'une porte réalisée sur arséniure de gallium.

C'est pourquoi les utilisateurs de circuits intégrés recherchent des circuits du type "prédiffusés" réalisés "à la demande" qui présentent à la fois les avantages des circuits réalisés sur l'arséniure de gallium et qui soient éventuellement en même temps compatibles avec la logique ECL.

Or, les portes réalisées à ce jour, en "circuit prédiffusé" sur l'arséniure de gallium, ne sont pas compatibles avec la logique ECL. Elles ne sont en effet compatibles qu'avec des portes identiques et ne peuvent donc être utilisées que comme "portes internes".

Lorsqu'un circuit réalisé à l'aide de ces portes doit être rendu compatible avec une autre logique alors un circuit d'interface doit être prévu sur deux niveaux. Un premier niveau de circuit dans lequel le dimensionnement et la polarisation des transistors sont changés par rapport au circuit de base, pour pouvoir attaquer le second niveau de circuit qui constitue le circuit d'interface proprement dit. Les portes constituant le premier niveau du circuit d'interface sont dites "portes externes".

Or dans la réalisation des "circuits à la demande" le concepteur de circuits cherche pour sa part à optimiser le rendement de la production tout en maintenant les performances techniques des circuits.

Il est alors clair que l'imbrication dans un "circuit prédiffusé" de portes internes et de portes externes dimensionnées et polarisées différemment, est en contradiction avec la réalisation d'un réseau simple et donc avec l'optimisation des rendements de fabrication du concepteur de "circuit à la demande".

C'est pourquoi la présente invention propose de résoudre ce problème en présentant un réseau de portes élémentaires tel que défini dans le préambule dont les portes peuvent être utilisées aussi bien comme "portes internes" que comme "portes externes" compatibles avec la technologie ECL.

Selon la présente invention ce réseau de portes est caractérisé en ce que les portes élémentaires qui constituent les éléments du réseau prédiffusé réalisent les fonctions OU/NON-OU en logique dite SCFL et constituent à la fois des portes internes pour le circuit à la demande et des portes externes compatibles avec la logique dite ECL pour connecter directement le circuit ainsi formé à un dispositif semiconducteur extérieur réalisé dans ladite logique ECL.

Les portes du réseau selon l'invention présentent alors l'avantage de pouvoir être utilisées aussi bien en "portes internes" qu'en "portes externes" compatibles avec la logique ECL, avec les mêmes tensions d'alimentation continues.

En "portes internes" elles sont capables d'attaquer directement une ou plusieurs portes du même type. En "portes externes" elles fournissent une amplitude de 700 mV sur une impédance de 60 $\Omega$ apte à attaquer une porte ECL. En outre elles présentent les très faibles temps de propagation et la très faible consommation propres aux circuits intégrés sur arséniure de gallium. Il en résulte que le "réseau prédiffusé" réalisé à l'aide de ces portes est particulièrement simple à réaliser et d'un bon rendement de fabrication. Le routage à prévoir par l'utilisateur sera alors également facilité. Le coût du "circuit à la demande" sera alors diminué.

L'invention sera mieux comprise à l'aide de la description suivante illustrée par les figures annexées dont :

-la figure 1a qui montre la porte externe, selon l'invention, sous forme de blocs ;

-la figure 1b qui montre une partie d'un réseau prédiffusé, selon l'invention, sous forme de blocs ;

-les figures 2 qui montrent en détail des portes internes selon l'invention ;

-la figure 3 qui montre en détail la porte externe selon l'invention.

Comme il a été dit précédemment une porte est dite interne lorsque son signal de sortie attaque directement une porte du même type, et une porte est dite externe lorsque son signal de sortie est en mesure d'attaquer directement une porte de type différent.

La porte choisie pour réaliser le réseau. de portes élémentaires prédiffusé (en anglais : gate-array), selon l'invention, permet de réaliser une famille logique entière, de par sa compatibilité en entrée/sortie avec la famille logique ECL, sa rapidité et sa faible consommation.

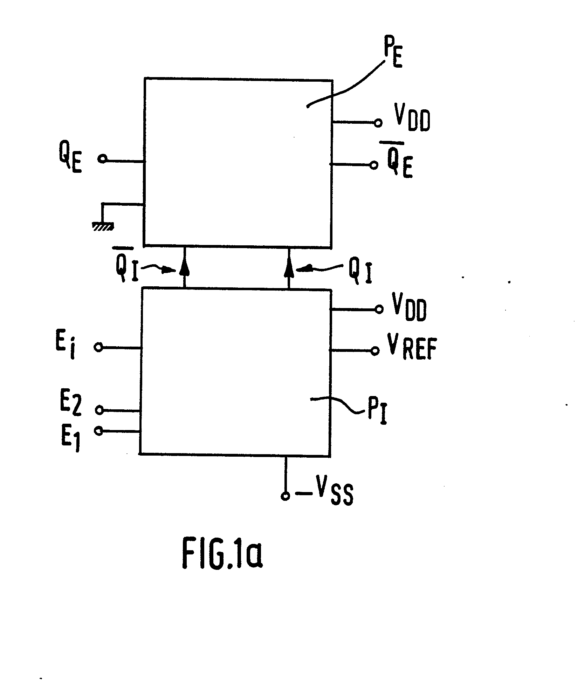

Telle que représentée sur la figure 1a, la porte élémentaire selon l'invention est apte à fournir sur sa sortie $Q_E$ ou sa sortie complémentaire $\overline{Q}_E$ la même amplitude que sur son entrée $E_i$, c'est-à-dire une amplitude de 700 mV obtenue entre le niveau bas de 0, 1V et le niveau haut de 0,8V, sur une charge de 60 $\Omega/2pF$. Ces caractéristiques sont tout à fait appropriées pour attaquer directement un circuit réalisé en logique dite ECL, extérieur au dispositif semiconducteur selon l'invention. De plus, le temps de propagation de cette porte est très rapide sur la charge de type capacitif.

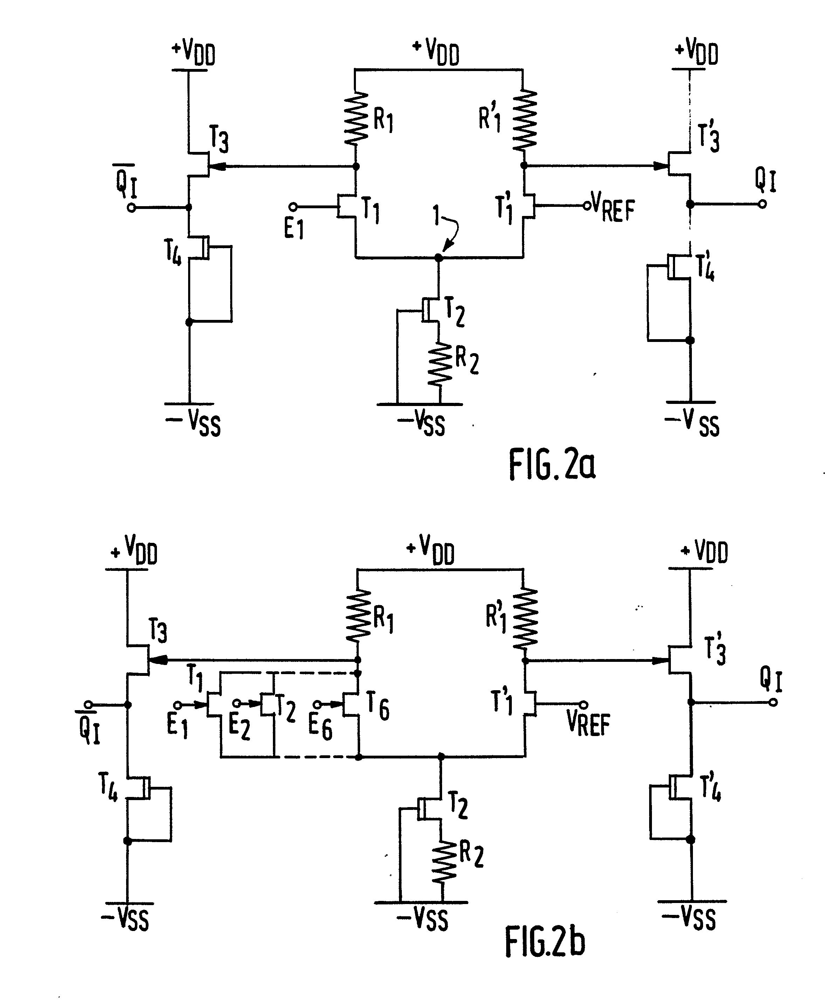

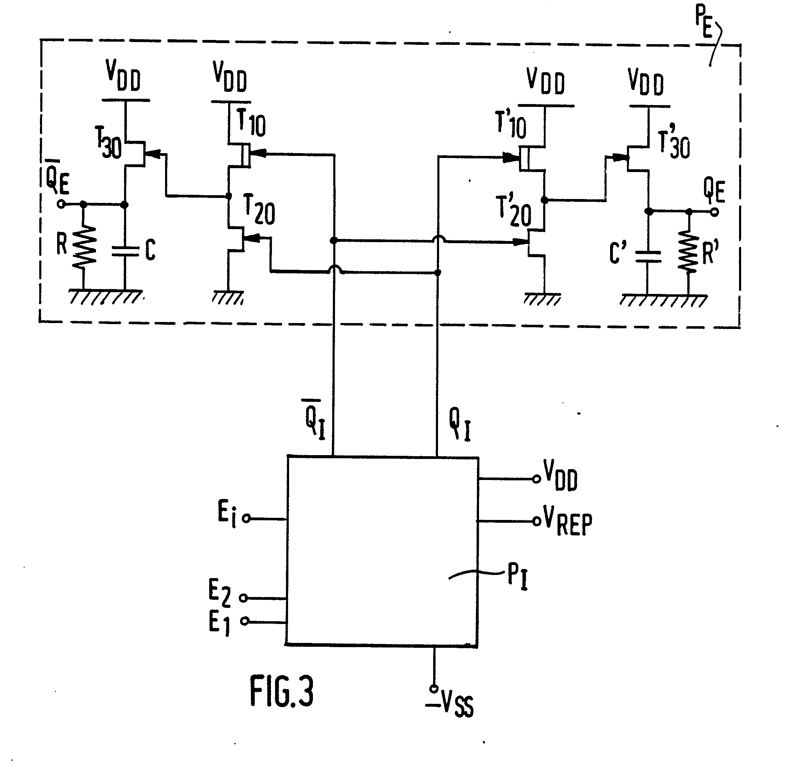

La porte selon l'invention est du type OU/NON-OU dérivée de la logique dite SCFL (en anglais : Source Coupled Field effect transistor Logic). Cette porte est formée d'un premier bloc $P_I$ dont la structure interne est représentée figures 2, et d'un second bloc $P_E$ dont la structure interne est représentée figure 3.

La structure du premier bloc $P_I$ réalise la fonction OU/NON-OU proprement dite. Telle que représentée sur la figure 2a elle est formée de deux transistors $T_1$ et $T'_1$ du type dit normalement pincé (en anglais : Normally-OFF) en l'absence de signal grille-source, couplés par leur source au noeud 1 et chargés respectivement par les charges $R_1$ et $R'_1$. Les sources couplées sont reliées à un transistor $T_2$ du type normalement passant en l'absence de signal grille-source (en anglais : Normally-ON) relié à une résistance $R_2$ et monté en source de courant reliée à l'alimentation continue négative $-V_{SS}$. Les charges $R_1$ et $R'_1$ sont d'autre part reliées à l'alimentation continue positive $+V_{DD}$. Les alimentations continues $V_{DD}$ et $-V_{SS}$ sont choisies symétriques.

La grille du transistor $T_1$ reçoit l'entrée $E_1$ et la grille du transistor $T'_1$ une tension de référence $V_{REF}$.

Les sorties des transistors $T_1$ et $T'_1$ prises respectivement entre $R_1$ et $R'_1$ sont portées sur les transistors suiveurs $T_3$ et $T'_3$ d'un étage tampon, reliés au transistors $T_4$ et $T'_4$ montés en translateurs de niveau. Les points milieux de l'étage tampon fournissent d'une part un signal $\overline{Q}_i$ et d'autre part un signal $Q_i$, le premier étant le complémentaire du second. Les transistors $T_3$ et $T'_3$ de l'étage tampon sont portés à la tension d'alimentation $+V_{DD}$, tandis que les transistors $T_4$ et $T'_4$ sont portés à la tension $-V_{SS}$.

Une porte élémentaire réalisée en logique SCFL sur arséniure de gallium était déjà connue de l'état de la technique par la publication de T.TAKADA et alii dans "Extended Abstracts of the 16th International Conference on solid State Devices and Materials, Kobe 1984, pp.403-406" intitulée "A GaAs HSCFL 4 GHz Divider with 60/70ps Transistion Time". Ce document décrit un circuit semiconducteur du type diviseur de fréquence comportant une porte élémentaire en logique SCFL (Source Coupled Field effect transistor Logic) réalisée à l'aide de transistors à effet de champ à appauvrissement dont la tension de pincement est très faible, de l'ordre de -1V, et dont la différence de potentiel entre le niveau haut et le niveau bas (en anglais : Logic Voltage Swing) est très grande, de l'ordre de 2,8 V ; d'où le nom donné à la logique constituée de telles portes : HSCFL (de l'anglais : High Logic Voltage Swing source Coupled Fet Logic). Le circuit réalisé à l'aide de cette porte élémentaire présente une grande vitesse de fonctionnement due au fait que la fréquence de coupure des transistors ainsi polarisés est très élevée.

En revanche, cette porte connue présente une forte consommation. C'est pourquoi il n'est pas possible d'envisager son utilisation dans les circuits prédiffusés où des densités d'au moins 2000 portes sont visées. De plus comme les autres portes réalisées sur arséniure de gallium et déjà utilisées dans les circuits prédiffusés, cette porte n'est pas compatible avec d'autres logiques.

Au contraire, la porte selon l'invention est d'une part compatible avec les portes de même type, et d'autre part compatible avec la logique ECL comme il est montré ci-après.

En ce qui concerne sa compatibilité avec les portes de même type, cette porte élémentaire admet une entrance de $\underline{6}$ , comme il est montré figure 2b.

Le tableau I donne les caractéristiques des transistors et des charges, qui sont dans cet exemple de réalisation de type résistif, pour obtenir avec cette porte :

une entrance FI = 6

une sortance FO = 4

un temps de propagation tpd = 75 ps

et une puissance consommée P = 10 mW.

La valeur des alimentations $V_{DD}$ = +1,5 V

$-V_{SS}$ = -l,5 V

Un avantage est tiré du fait que les alimentations $V_{DD}$ et $-V_{SS}$ sont symétriques, car ces alimentations sont aisées à réaliser à partir d'une inversion, une seule alimentation continue étant alors nécessaire.

| TABLEAU I | | | |
|---|---|---|---|
| Transistors | Type | Longueur de grille | Largeur de grille |
| $T_1$ à $T_6$ | Enrichis. | 0,7 µm | 20 µm |
| $T'_1$ | Enrichis. | 0,7 µm | 40 µm |
| $T_2$ | Désertion | 0,7 µm | 18 µm |
| $T_3, T'_3$ | Enrichis. | 0,7 µm | 30 µm |
| $T_4, T'_4$ | Désertion | 0,7 µm | 17 µm |
| Charges | Type | Valeur | |
| $R_1, R'_1$ | Résistance | 1,8 KΩ | |
| $R_2$ | Résistance | 0,7 KΩ | |

La tension de seuil des transistors à désertion de charge (en anglais Normally-ON) est $V_T$ = -0,8V.

La tension de seuil des transistors à enrichissement (en anglais Normally-OFF) est $V_T$ = 50 mV.

Ces transistors présentent un courant de saturation $I_{DSS}$ à la tension grille-source $V_{GS}$ = 0,7 V qui est :

$I_{DSS}$ = 15 mA pour des transistors à enrichissement de largeur de grille 200 µm

et $I_{DSS}$ = 44 mA pour les transistors à désertion de largeur de grille 200 µm

et une transconductance maximale :

$g_m$ = 220 mS/mm tant pour les transistors à désertion qu'à enrichissement.

La tension de référence a été choisie telle que :

$V_{REF}$ = 0,4 V.

4

Dans l'exemple de réalisation décrit précédemment, la porte élémentaire selon l'invention réalise donc les fonctions OU et NON-OU sur les deux branches de sortie $Q_I$ et $\overline{Q}_I$. Le dimensionnement est choisi pour :

-Minimiser les effets de fuite s'ajoutant sur les six transistors en parallèle $T_1$ à $T_6$ lorsque ceux-ci sont en position bloquée.

-Minimiser l'influence de la sortance par l'intermédiaire des étages tampons décaleurs.

-Assurer une stabilisation du courant en mode commun.

Le gain de cette porte dans l'exemple de réalisation décrit est :

$G \simeq 1,8$

ce qui permet d'obtenir une grande rapidité en gardant une marge de bruit minimale.

Tel que réalisé selon l'invention, le bloc $P_I$ représenté Fig. 1a, 2a et 2b peut constituer à lui seul des portes de circuit interne.

Pour sa pleine compatibilité avec les circuits ECL, les sorties du bloc $P_I$ sont reportées sur les entrées du bloc $P_E$ comme montré Fig. 1a, et Fig. 3.

Ce bloc $P_E$ est illustré en détail fig. 3. Les sorties $\overline{Q}_I$ et $Q_I$ du bloc $P_I$ sont portées respectivement sur les grilles des transistors hauts $T_{10}$ et $T'_{10}$ de deux étages de type PUSH-PULL qui comprennent en outre les transistors bas $T_{20}$ et $T'_{20}$. Ces derniers reçoivent respectivement les sorties $Q_I$ et $\overline{Q}_I$ du bloc $P_I$ c'est-à-dire le signal complémentaire de celui qui est reçu par les transistors hauts. Les transistors hauts des étages PUSH-PULL sont du type à désertion (Normally-ON) et reliés à l'alimentation continue $V_{DD}$. Les transistor bas des étages PUSH-PULL sont du type à enrichissement et reliés à la masse.

Ces étages PUSH-PULL sont symétriques. Les signaux pris aux points milieux des étages PUSH-PULL sont reportés sur des étages tampons formés pour l'un par le transistor $T_{30}$, la résistance R et la capacité C, et pour l'autre par le transistor $T'_{30}$, la résistance R' et la capacité C'. Les transistor $T_{30}$ et $T'_{30}$ sont à enrichissement (Normally-OFF) et reliés à l'alimentation continue $V_{DD}$. Les sorties $\overline{Q}_E$ et $Q_E$ de la porte élémentaire globale totalement compatible avec la logique ECL se fait sur la seconde électrode des transistors $T_{30}$ et $T'_{30}$ qui est reliée à la résistance et la capacité R et C en parallèle pour l'un et R' et C' en parallèle pour l'autre. Ces résistances R et R', et ces capacités C et C' sont d'autre part reliées à la masse.

Comme il a été dit précédemment les caractéristiques des éléments du bloc $P_E$ sont choisies pour obtenir la même amplitude qu'en entrée de porte, cette amplitude A étant en outre l'amplitude requise pour la compatibilité avec la logique ECL, c'est-à-dire :

A = 700 MV entre le niveau bas à 0,1 V et le niveau haut à 0,8 V, sur la charge formée de :

R = R' = 60 $\Omega$, et la capacité

C = C' = 2 pF.

Le temps de propagation de la porte lorsque les caractéristiques données dans le tableau II sont respectées est :

tpd = 130 ps sur 60 $\Omega$/2pF

$T_R$, $T_f$ (20-80 %) = 160 ps

et la puissance consommée :

P = 35 mW en incluant les charges de 60 $\Omega$.

On notera qu'un grand avantage est tiré du fait que l'alimentation continue est encore $+V_{DD} = +1,5$ V, ce qui simplifie considérablement le routage. En effet, il est connu que lors de l'implantation de circuit, le routage des alimentations, spécialement si elles sont nombreuses, occupe une grande surface.

| TABLEAU II | | | |
|---|---|---|---|
| Transistors | Type | Longueur de grille | Largeur de grille |
| $T_{30}$, $T'_{30}$ | Enrichis. | 0,7 $\mu$m | 350 $\mu$m |
| $T_{10}$, $T'_{10}$ | Désert. | 0,7 $\mu$m | 90 $\mu$m |
| $T_{20}$, $T'_{20}$ | Enrichis. | 0,7 $\mu$m | 60 $\mu$m |

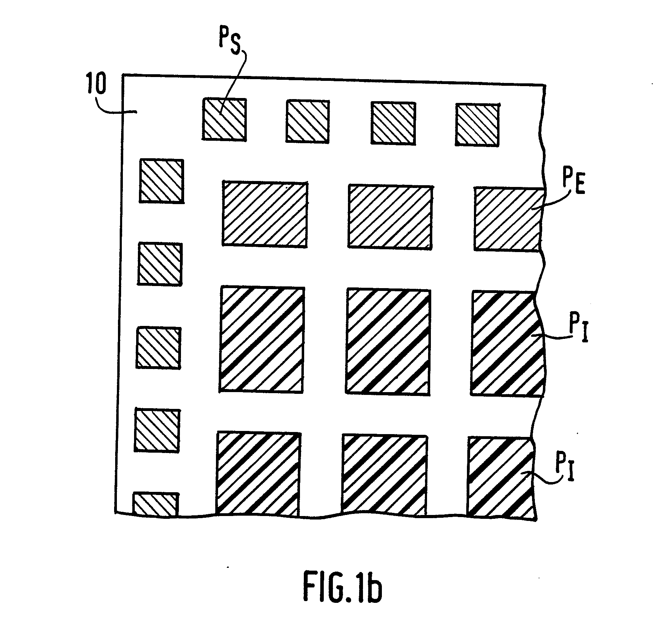

La figure 1b montre un exemple de module de réseau de portes tel qu'il apparaît à l'utilisateur avant le projet de routage. Les blocs $P_I$ e $P_E$ sont distribués de façon régulière sur un substrat 10, de préférence en arséniure de gallium (ou un composé du groupe III-V). Les blocs référencés $P_S$ sont des plages métalliques constituants les plots d'entrées/sorties. La figure 1b ne représente qu'une partie du substrat.

Il est évident que dans la réalisation pratique des jeux de masques qui permettent la concrétisation du circuit complet sur un substrat semiconducteur l'outil informatique est indispensable. Cet outil permet des simulations électriques logiques, la génération de vecteurs de test, le tracé des topologies d'implantation des transistors, puis des blocs et des interconnexions.

D'autre part, il est clair qu'une technologie telle que celle qui est proposée dans la présente invention est particulièrement favorable à l'intégration d'un nombre élevé de portes, du fait de la très faible consommation de chacune d'entre elles.

## Revendications

1. Dispositif semiconducteur du type réseau de portes élémentaires prédiffusé pour constituer un circuit intégré dit circuit à la demande, réalisé selon une technologie de circuit intégré sur arséniure de gallium, caractérisé en ce que les portes élémentaires qui constituent les éléments du réseau prédiffusé réalisent les fonctions OU/NON-OU en logique dite SCFL et constituent à la fois des portes internes pour le circuit à la demande et des portes externes compatibles avec la logique dite ECL pour connecter directement le circuit ainsi formé à un dispositif semiconducteur extérieur réalisé dans ladite logique ECL.

2. Dispositif selon la revendication 1, caractérisé en ce que ces portes externes sont formées de deux blocs $P_I$ et $P_E$.

3. Dispositif selon la revendication 2, caractérisé en ce que l'un de ces deux blocs dit premier bloc $P_I$ constitue à lui seul une porte dite interne.

4. Dispositif selon la revendication 3, caractérisé en ce que le premier bloc $P_I$ est formé d'abord d'un transistor $T'_1$ connecté à une alimentation continue $V_{DD}$ à travers une charge $R'$, commandé par un signal de référence $V_{REF}$, et couplé par sa source à une cascade de 1 à 6 transistors $T_1... T_6$, dont les drains communs sont connectés à l'alimentation $V_{DD}$ à travers une charge R dont les grilles reçoivent les signaux de commande $E_1...E_6$, les sources communes des transistors $T'_1$ et $T_1...T_6$ étant alimentées en courant à partir d'une tension continue $-V_{SS}$ d'une part symétrique de la tension $V_{DD}$ et d'autre part telle que :
$$-V_{SS} < V_{REF} < V_{DD},$$
à l'aide d'un transistor à effet de champ $T_2$ et d'une charge $R_2$ formant une source de courant, et est formé ensuite de deux étages tampons, constitués respectivement d'un transistor suiveur $T_3$ ou $T'_3$ relié à un transistor $T_4$ ou $T'_4$ monté en translateur de niveau, le drain du transistor suiveur $T_3$ ou $T'_3$ étant relié à l'alimentation continue $V_{DD}$ et la grille du transistor suiveur $T_3$ ou $T'_3$ étant commandée par le signal prélevé sur le drain commun des transistors $T_1... T_6$ et $T'_1$, les sortie $\overline{Q}_I$ et $Q_I$ de fonction NON-OU et OU respectivement, étant disponibles sur la source du transistor $T_3$ d'une part et sur la source du transistor $T'_3$ d'autre part.

5. Dispositif selon la revendication 4, caractérisé en ce que les transistors $T_1... T_6$, $T'_1$, $T_3$, $T'_3$ sont du type dit transistors à effet de champ à enrichissement, les transistors $T_2$, $T_4$, $T'_4$ sont du type dit transistors à effet de champ à désertion de charges, et les charges R, $R'_1$ et $R_2$ sont du type résistif.

6. Dispositif selon l'une des revendication 2 à 5, caractérisé en ce que le second bloc $P_E$ est formé de deux étages dit PUSH-PULL, constitués respectivement d'un transistor haut, $T_{10}$ ou $T'_{10}$ dont le drain est porté à la tension $V_{DD}$, et d'un transistor bas $T_{20}$ ou $T'_{20}$ dont la source est portée à la masse et formé de deux étages tampons constitués respectivement d'un transistor $T_{30}$ ou $T'_{30}$ commandé par les signaux issus du point milieu d'un étage PUSH-PULL, dont le drain est relié à l'alimentation continue $V_{DD}$ et dont la source est reliée à la masse à travers une charge formée d'une résistance et une capacité en parallèle, respectivement R, C ou R' C', chaque sortie $\overline{Q}_I$ ou $Q_I$ du premier bloc $P_I$ pouvant être appliquée à la fois sur le transistor haut de l'un des étages PUSH-PULL, et sur le transistor bas de l'autre étage PUSH-PULL, et les sorties $\overline{Q}_E$ et $Q_E$ du bloc $P'_E$, compatibles avec la logique ECL, étant disponibles sur la source des transistors $T_{30}$ ou $T'_{30}$ des étages tampons.

7. Dispositif selon la revendication 6, caractérisé en ce que les transistors $T'_{20}$, $T_{20}$, $T_{30}$, $T'_{30}$ sont du type dit transistor à effet de champ à enrichissement et les transistors $T'_{10}$ et $T_{10}$ sont du type dit transistor à effet de champ à désertion de charge.

8. Dispositif selon l'une des revendications 1 à 7, caractérisé en ce que les portes de ces réseaux sont intégrées sur un substrat en arséniure de gallium ainsi que des plots métalliques $P_S$ pour les entrées/sorties.

FIG.1a

FIG.1b

FIG.2a

FIG.2b

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,Y | JAPANESE JOURNAL OF APPLIED PHYSICS. SUPPLEMENTS 16th INTERNATIONAL CONFERENCE ON SOLID STATE DEVICES AND MATERIALS, Kobe, 30 août - 1er septembre 1984, pages 403-406, Tokyo, JP; T. TAKADA et al.: "A GaAs HSCFL 4 GHz divider with 60/70 ps transition time" * Figures 1,4a,4b; page 403, colonne de gauche, dernière ligne - colonne de droite, ligne 1; page 405, colonne de gauche, lignes 2-7,11-21 * | 1-5,8 | H 03 K 19/094 H 03 K 19/173 |
|  | --- |  |  |
| Y | EP-A-0 153 774 (L.E.P.) * Figures 1,2; page 6, ligne 1 - page 7, ligne 26 * | 1-5,8 |  |
|  | --- |  | DOMAINES TECHNIQUES RECHERCHES (Int. Cl.4) |
| A | PATENT ABSTRACTS OF JAPAN, vol. 7, no. 267 (E-213)[1412], 29 novembre 1983; & JP-A-58 151 053 (MATSUSHITA DENKI SANGYO K.K.) 08-09-1983 * Figures * | 1,2,6, 8 | H 03 K |
|  | --- |  |  |
| A | US-A-4 496 856 (RANSOM et al.) * Figures 1,2; colonne 2, ligne 23 - colonne 4, ligne 40 * | 1,6 |  |
|  | ---        -/- |  |  |

Le présent rapport de recherche a été établi pour toutes les revendications

| Lieu de la recherche | Date d'achèvement de la recherche | Examinateur |
|---|---|---|
| LA HAYE | 27-05-1987 | FEUER F.S. |

## DOCUMENTS CONSIDERES COMME PERTINENTS

Page  2

| Catégorie | Citation du document avec indication, en cas de besoin, des parties pertinentes | Revendication concernée | CLASSEMENT DE LA DEMANDE (Int. Cl.4) |
|---|---|---|---|
| A | JAPANESE JOURNAL OF APPLIED PHYSICS. SUPPLEMENTS 16th INTERNATIONAL CONFERENCE ON SOLID STATE DEVICES AND MATERIALS, Kobe, 30 août - 1er septembre 1984, pages 399-402, Tokyo, JP; K. TANAKA et al.: "Super-buffer FET logic (SBFL): a logic gate suitable to GaAs LSI's" * Figure 1a; page 399, colonne de gauche, dernière ligne - colonne de droite, lignes 1-11 * | 1,6,7 | |
| | --- | | |
| A | US-A-4 410 815  (RANSOM et al.) | 1 | |
| | --- | | |
| A | EP-A-0 085 569  (SPERRY CORP.) | 1 | |
| | --- | | DOMAINES TECHNIQUES RECHERCHES (Int. Cl.4) |
| A | IEEE JOURNAL OF SOLID-STATE CIRCUITS, vol. SC-19, no. 1, février 1984, pages 10-22, IEEE, New York, US; T.T. VU et al.: "A gallium arsenide SDFL gate array with on-chip RAM" | 1 | |
| | --- | | |
| P,A | IEEE INTERNATIONAL SOLID-STATE CIRCUITS CONFERENCE, 19 février 1986, ISSCC Digest of Technical Papers, pages 72-74, Lewis Winner; H. HIRAYAMA et al.: "Session VII: Semi-custom arrays" * Figures 1,2a,2b; page 72 * | 1 | |
| | ---        -/- | | |

Le présent rapport de recherche a été établi pour toutes les revendications

| Lieu de la recherche | Date d'achèvement de la recherche | Examinateur |
|---|---|---|
| LA HAYE | 27-05-1987 | FEUER F.S. |

| | **DOCUMENTS CONSIDERES COMME PERTINENTS** | | Page  3 |
|---|---|---|---|

| Catégorie | Citation du document avec indication, en cas de besoin, des parties pertinentes | Revendication concernée | CLASSEMENT DE LA DEMANDE (Int. Cl.4) |
|---|---|---|---|
| P,A | EP-A-0 200 230  (NEC CORP.)<br>* Figures 1,2; page 1, ligne 1  -<br>page 11, ligne 34 *<br><br>-----| 1 | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 27-05-1987 | FEUER F.S. |